# EUROPEAN PATENT APPLICATION

(11) **EP 4 848 929 A1**
(43) Date of publication of application: **02.12.2026**
(21) Application number: 24920072.6
(22) Date of filing: 23.12.2024
(51) Int. Cl.: H10D 8/50, H10D 30/66, H10D 62/10

(54) **SEMICONDUCTOR DEVICE**

(30) Priority: 22.01.2024 JP 2024007680
(71) Applicant: Shindengen Electric Manufacturing Co., Ltd., Tokyo 100-0004 (JP)
(72) Inventor: NAKAMURA, Hideyuki, Asaka City, Saitama 3518503 (JP); MATSUZAKI, Yoshifumi, Asaka City, Saitama 3518503 (JP); ITO, Hiromi, Asaka City, Saitama 3518503 (JP)
(74) Representative: Liesegang, Eva
(86) International application number: PCT/JP2024/045547
(87) International publication number: WO 2025/158849

(57) **Abstract**

A semiconductor device 1 includes: a semiconductor substrate 10; an activation region-side electrode 20; an insulation layer 30; and a field plate 40. The semiconductor substrate 10 includes: a substrate region 12 of a first conductive type; an activation region 14 of a second conductive type that has a plurality of first corner portions 14a and a plurality of first side portions 14b; a surface semiconductor region 16 of the second conductive type that is formed on the first main surface side to be in contact with an outer periphery of the activation region as viewed in a plan view, and has a smaller total amount of dopant than the activation region 14; and a first region 18 that is formed to be positioned inside the corresponding first side portions 14b as viewed in a plan view, and has a smaller total amount of dopant than the activation region 14. According to the semiconductor device 1, the semiconductor device 1 can achieve the miniaturization of a semiconductor device while achieving a higher withstand voltage than that of a semiconductor device having a guard ring structure, and can enhance the withstand capability of the entire device.

## Description

### [Cross Reference]

This application claims priority based on Japanese Patent Application No. 2024-7680 filed in Japan on January 22, 2024, and the entire contents of the application are incorporated herein by reference.

### [Technical Field]

The present invention relates to a semiconductor device.

### [Background Art]

Conventionally, there has been known a semiconductor device in which a guard ring is formed in a peripheral region (a semiconductor device having a guard ring structure), (see, for example, Patent Literature 1). Hereinafter, a semiconductor device 900 that is an example of a conventional semiconductor device (hereinafter, referred to as "conventional semiconductor device 900") will be briefly described.

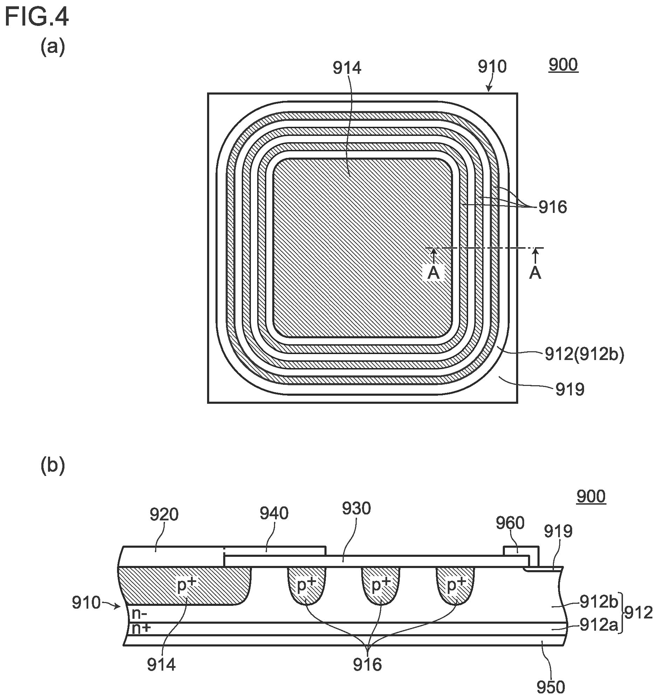

As illustrated in Fig. 4, the conventional semiconductor device 900 includes: a semiconductor substrate 910; an activation region-side electrode 920 that is disposed on a first main surface of the semiconductor substrate 910; an insulation layer 930 that is in contact with the outer periphery of the activation region-side electrode 920, and is disposed on the first main surface; a field plate 940 that is in contact with the outer periphery of the activation region-side electrode 920, and is disposed on the insulation layer 930; a second electrode 950; and a channel stop electrode 960.

The semiconductor substrate 910 includes: an n-type base region 912 having an n⁺-type semiconductor region 912a and an n⁻-type semiconductor region 912b; a p⁺-type activation region 914 formed on a first main surface side such that at least a portion of the p⁺-type activation region 914 overlaps with the activation region-side electrode 920 as viewed in a plan view; a plurality of guard rings 916 formed so as to surround the periphery of the activation region 914 in a spaced-apart manner as viewed in a plan view; and a channel stopper 919. The activation region-side electrode 920 and the field plate 940 form a first electrode.

In the conventional semiconductor device 900, the semiconductor substrate 910 has the plurality of guard rings 916 on the peripheral region thereof. Accordingly, when a reverse bias is applied, a depletion layer that spreads from a pn junction between the activation region 914 and the substrate region 912 can spread to the peripheral region, and a curvature of the depletion layer can be made small. As a result, according to the conventional semiconductor device 900, it is possible to increase a withstand voltage compared to a case where the semiconductor substrate 910 does not have a guard ring 916.

### [Prior Art Literature]

### [Patent Literature]

[Patent Literature 1] JP-A-10-173174

### [Summary of Invention]

### [Technical Problem]

To enable a semiconductor device having a guard ring structure such as the conventional semiconductor device 900 to achieve a high withstand voltage, it is necessary to increase the number of guard rings. However, to increase the number of guard rings, it is necessary to widen an area of a peripheral region. Accordingly, the semiconductor device having the guard ring structure has a drawback that it is difficult to achieve the miniaturization while maintaining a high withstand voltage.

Further, in the semiconductor device having the guard ring structure, when a reverse bias is applied, it is often the case that a withstand voltage at a corner portion is smaller than a withstand voltage at a side portion. For example, at a vertex of a corner portion of the guard ring 916 in the conventional semiconductor device 900, due to charge balance considerations, it is difficult to extend the depletion layer. As in the case of the conventional semiconductor device 900, in a case where an outer periphery of a corner portion of the guard ring forms an arcuate shape having a center angle of 90° as viewed in a plan view, the vertex of the corner portion of the guard ring becomes a point positioned at a central angle of 45°.

In the semiconductor device having the guard ring structure, an avalanche breakdown occurs in the vicinity of the vertex of the corner portion of the above-mentioned guard ring prior to the peripheral portion of the guard ring and hence, current density of the corner portion is increased. As a result, there is a drawback that a withstand capability is lowered over the entire device.

The present invention has been made to overcome the above-mentioned problem, and it is an object of the present invention to provide a semiconductor device that can achieve the miniaturization while achieving a higher withstand voltage than a semiconductor device having a guard ring structure, and can increase the withstand capability of the entire device.

### [Solution to Problem]

A semiconductor device according to the present invention includes: a semiconductor substrate; an activation region-side electrode disposed on a first main surface of the semiconductor substrate; an insulation layer being in contact with an outer periphery of the activation region-side electrode, and disposed on the first main surface; and a field plate being in contact with the outer periphery of the activation region-side electrode, and disposed on the insulation layer, wherein the semiconductor substrate includes: a substrate region of a first conductive type; an activation region of a second conductive type that is formed on the first main surface side such that at least a portion of the activation region overlaps with the activation region-side electrode as viewed in a plan view, and has a plurality of first corner portions and a plurality of first side portions; a surface semiconductor region of the second conductive type that is formed on the first main surface side to be in contact with an outer periphery of the activation region as viewed in a plan view, and has a smaller total amount of dopant than the activation region; and a first region that is formed to be positioned inside the corresponding first side portions of the activation region as viewed in a plan view, and has a smaller total amount of dopant than the activation region.

### [Advantageous Effects of the Present Invention]

In the semiconductor device according to the present invention, the semiconductor substrate includes the surface semiconductor region of the second conductive type that is formed on the first main surface side to be in contact with the outer periphery of the activation region as viewed in a plan view, and has a smaller total amount of dopant than the activation region. In the semiconductor device according to the present invention, both the substrate region and the surface semiconductor region can be depleted when a reverse bias is applied and hence, it is unnecessary to increase an area of the peripheral region to obtain a high withstand voltage. Therefore, according to the semiconductor device of the present invention, it is possible to achieve the miniaturization of the semiconductor device while achieving a higher withstand voltage than a semiconductor device having a guard ring structure.

Further, in the semiconductor device according to the present invention, the semiconductor substrate includes the first region that is formed to be positioned inside the corresponding first side portions as viewed in a plan view, and has a smaller total amount of dopant than the activation region. A withstand voltage is determined based on the area over which the depletion layer spreads. In the semiconductor device according to the present invention, the first region is formed inside the first side portion of the activation region and hence, the spreading of the depletion layer in the vicinity of the first region is reduced thereby lowering a withstand voltage in the side portion. Accordingly, in the semiconductor device of the present invention, it is possible to facilitate the occurrence of an avalanche breakdown at the side portion when a reverse bias is applied and hence, a withstand capability of the entire device can be enhanced.

Accordingly, the present invention provides a semiconductor device that can achieve the miniaturization while achieving a higher withstand voltage than a semiconductor device having a guard ring structure, and can enhance a withstand capability of the entire device.

### [Brief Description of Drawings]

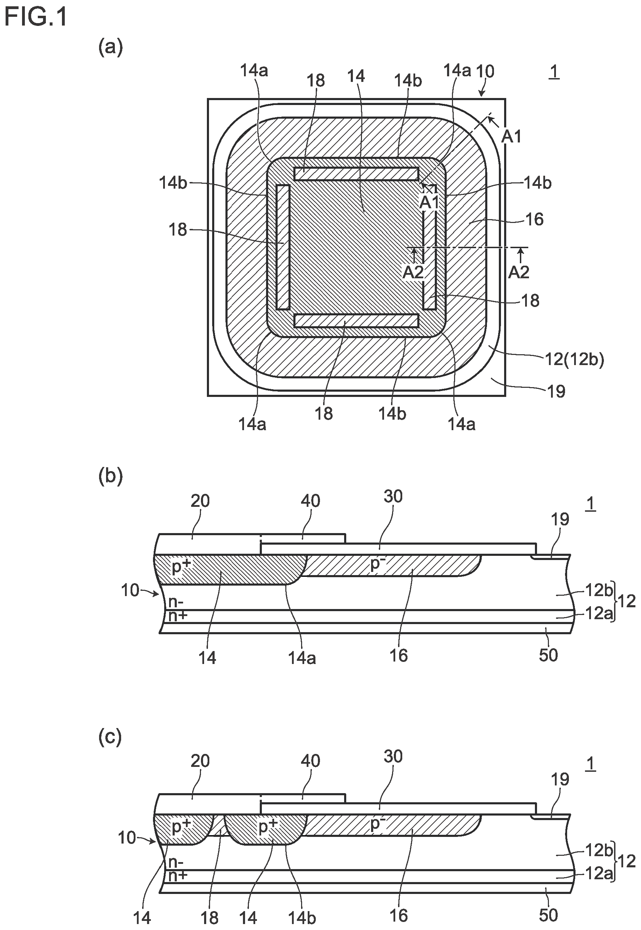

Fig. 1 is a view describing a semiconductor device 1 according to an embodiment 1. Fig. 1(a) is a plan view of the semiconductor device 1. Fig. 1(b) is a cross-sectional view taken along a line A1-A1 in Fig. 1(a) (a cross-sectional view including a first corner portion 14a). Fig. 1(c) is a cross-sectional view taken along a line A2-A2 in Fig. 1(a) (a cross-sectional view including a first side portion 14b). In the present specification, the term "plan view" refers to a view of the semiconductor device as viewed from a first main surface side of a semiconductor substrate (a side where an activation region-side electrode is disposed). In Fig. 1(a), to illustrate the shape of an activation region 14, the shape of a surface semiconductor region 16 and the shape of a first region 18, an activation region-side electrode 20, an insulation layer 30 and a field plate 40 are not illustrated. Also, in other plan views illustrated later relating to the embodiment other than Fig. 1(a), the manner of illustration of the respective components is substantially equal to the manner of illustration adopted by Fig. 1(a).

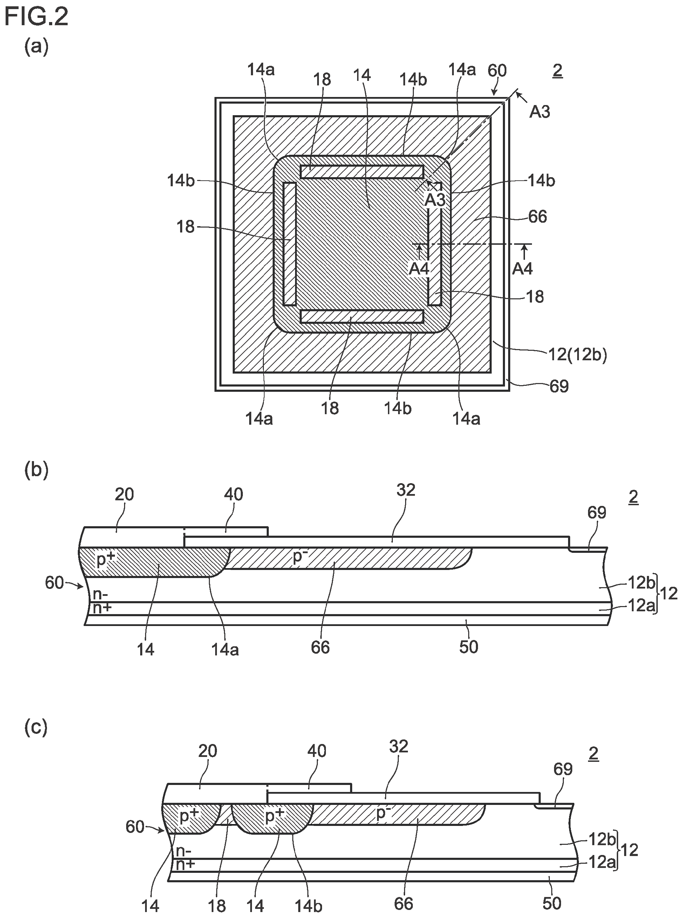

Fig. 2 is a view describing a semiconductor device 2 according to an embodiment 2. Fig. 2(a) is a plan view of the semiconductor device 2. Fig. 2(b) is a cross-sectional view taken along a line A3-A3 in Fig. 2 (a) (cross-sectional view including the first corner portion 14a). Fig. 2(c) is a cross-sectional view taken along a line A4-A4 in Fig. 2(a) (cross-sectional view including the first side portion 14b).

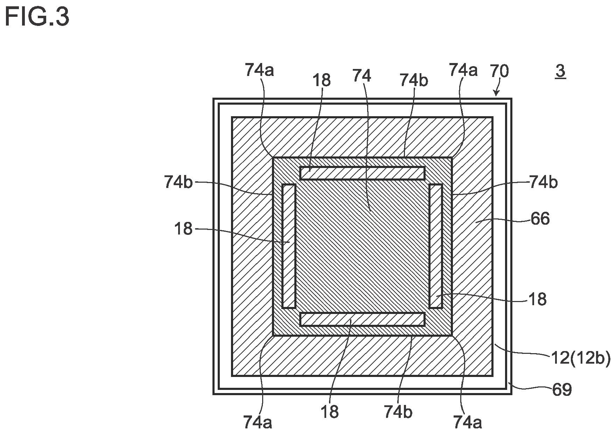

Fig. 3 is a plan view describing a semiconductor device 3 according to a modification.
Fig. 4 is a view describing a conventional semiconductor device 900. Fig. 4(a) is a plan view of the semiconductor device 900. Fig. 4(b) is a cross-sectional view taken along a line A-A in Fig. 4(a). In Fig. 4(a), to illustrate the shape of the activation region 914 and the shape of the guard ring 916, an activation region-side electrode 920, an insulation layer 930 and a field plate 940 are not illustrated.

### [Description of Embodiments]

Hereinafter, a semiconductor device according to the present invention is described with reference to embodiments illustrated in drawings. In the respective embodiments described hereinafter, with respect to components that have completely same functions or substantially same functions, there may be a case where common reference numerals are used in the respective embodiments even when the shapes and the like are different more or less, and the descriptions which are made already are omitted. The respective embodiments described hereinafter do not limit the inventions called for in claims. Further, it is not always the case that various components and all combinations of these components described in the respective embodiments are indispensable in the means for solving the problem of the present invention.

### [Embodiment 1]

A semiconductor device 1 according to an embodiment 1 is a planar-type diode. As illustrated in Fig. 1, the semiconductor device 1 includes a semiconductor substrate 10, an activation region-side electrode 20, an insulation layer 30, a field plate 40, and a second electrode 50. The activation region-side electrode 20 and the field plate 40 constitute a first electrode. The semiconductor device 1 may include components other than the above-mentioned components. Among the respective drawings including the drawings that constitute Fig. 1, the drawing that illustrates the configuration of the semiconductor device is a schematic view and hence, sizes of the components and the like displayed in the drawings do not necessarily correspond to sizes of actual components and the like. Hereinafter, the respective components are described.

The semiconductor substrate 10 includes a substrate region 12, an activation region 14, a surface semiconductor region 16, a first region 18, and a channel stopper 19. A material of the semiconductor substrate 10 is Si, for example.

The substrate region 12 is a region of a first conductive type (n-type in the semiconductor device 1) having an n⁺-type semiconductor region 12a and an n⁻-type semiconductor region 12b. Surface dopant concentration of the n⁺-type semiconductor region 12a can be set to 1 × 10²⁰cm⁻³ or more, for example. Further, a depth of the n⁺-type semiconductor region 12a from a second main surface side (second electrode 50 side) (a thickness of the n⁺-type semiconductor region 12a) can be set to 5 to 90 µm, for example. Surface dopant concentration of the n⁻-type semiconductor region 12b is lower than that of the n⁺-type semiconductor region 12a and can be set to 5.0 × 10¹³ cm⁻³ to 4.0 × 10¹⁴ cm⁻³. Further, a thickness of the n⁻-type semiconductor region 12b can be set to 40 to 200 µm, for example.

An activation region 14 is formed on a first main surface side such that at least a portion of the activation region 14 overlaps with an activation region-side electrode 20 as viewed in a plan view. The activation region 14 is a region of a second conductive type (p-type in the semiconductor device 1) having a plurality of first corner portions 14a and a plurality of first side portions 14b. In this specification, "as viewed in a plan view" means that a target component that is a viewing object is viewed from a first main surface side of the semiconductor substrate (a side where the activation region-side electrode is disposed). In this specification, "the first corner portions" means corner portions of an outer periphery of the activation region. It can be said that "the first corner portion" is a portion that connects two first side portions whose directions are different. In this specification, "the first side portions" means straight portions of the outer periphery of the activation region. In this embodiment, "the outer periphery" of the region that the semiconductor substrate has does not refer to a tip of a side diffusion portion where a depth of the region sharply decreases but an outer periphery of a portion where the depth (the thickness) of the region is substantially constant.

In this specification, when a portion is simply described as "corner portion" without referring to a specific region, "the corner portion" means a portion disposed on an outer peripheral side of the activation region, including the first corner portion in the semiconductor device. For example, it can be said that Fig. 1(b) is a cross-sectional view illustrating the corner portion of the semiconductor device 1. Further, in this specification, when a portion is simply described as "side portion" without referring to a specific region, "the side portion" means a portion disposed on an outer peripheral side of the activation region including the first side portion in the semiconductor device. For example, it can be said that Fig. 1(c) is a cross-sectional view illustrating the side portion of the semiconductor device 1.

The activation region 14 in the semiconductor device 1 is a region having an outer periphery where a plurality of first corner portions 14a and a plurality of first side portions 14b are alternately arranged. The activation region 14 includes four first corner portions 14a and four first side portions 14b, and the first corner portion 14a is formed in an arcuate shape having a central angle of 90°. Accordingly, the activation region 14 has a substantially quadrangular shape with rounded corners when viewed in a plan view. Surface dopant concentration of the activation region 14 can be set to 1 × 10¹⁶ cm⁻³ to 5 × 10¹⁹ cm⁻³, for example. Further, a total amount of dopant of the activation region 14 can be set to 1.7 × 10¹² cm⁻² or more, for example. A depth of the activation region 14 is set to 4 µm to 10 µm, for example.

A maximum depth of the activation region 14 is greater than a maximum depth of the surface semiconductor region 16. The term "depth" of a region of the semiconductor substrate is set with reference to a first main surface when the reference is not particularly specified.

The surface semiconductor region 16 is a region that is formed on the first main surface side such that the surface semiconductor region 16 is in contact with an outer periphery of the activation region 14 as viewed in a plan view, the region being of the second conductive type (p-type in the semiconductor device 1) having a smaller total amount of dopant than the activation region 14. In this specification, "total amount of dopant" is a value obtained by integrating the concentration distributions of dopants in the depth direction from the surface (an amount of activated dopant per unit area). The total amount of dopant is the value that also relates to a dose amount (an injected dopant amount). However, it is not always the case that an appropriate correlation is obtained between a withstand voltage and a dose amount. This is because the dopant amount may change due to heat treatment.

The surface semiconductor region 16 is formed in a substantially quadrangular shape with round corners as viewed in a plan view. A total amount of dopant of the surface semiconductor region 16 can be set to 0.5 × 10¹² cm⁻² to 1.25 × 10¹² cm⁻², for example. A depth of the surface semiconductor region 16 is set to 3 µm to 6 µm, for example.

The first regions 18 in the semiconductor device 1 are regions that are formed so as to be positioned inside the corresponding first side portions 14b as viewed in a plan view, and have a smaller total amount of dopant than the activation region 14. It can be said that the first regions 18 are regions that are formed so as to be positioned inside the first side portions 14b and are the regions where the activation region 14 is not formed. It can be said that "inside the first side portions" is the activation region-side when the first side portions are used as the reference.

The first regions 18 in the semiconductor device 1 are regions of a second conductive type (p-type in the semiconductor device 1) having a smaller total amount of dopant than the activation region 14. A maximum depth of the first region 18 in the semiconductor device 1 is shallower than a maximum depth of the activation region 14. The total amount of dopant and the maximum depth of the first region 18 can be set substantially equal to the total amount of dopant and the maximum depth of the surface semiconductor region 16, for example. The first region 18 in the semiconductor device 1 is formed in a strip shape extending in a direction along the first side portion 14b as viewed in a plan view. In the semiconductor device 1, four first regions 18 are formed corresponding to four first side portions 14b. The first regions 18 are not formed inside the first corner portions 14a.

In a cross-sectional view of the semiconductor device 1, a portion where three components consisting of the semiconductor substrate 10, the activation region-side electrode 20 and the insulation layer 30 are in contact with each other is assumed as a contact edge. The contact edge is a portion where a crystal strain is generated so that the withstand capability tends to decrease. It is preferred that the surface dopant concentration of the semiconductor substrate 10 at the contact edge is increased thus relaxing the depletion layer. For this end, the first regions 18 are formed on a more inner peripheral side than the contact edges. To ensure the level of the surface dopant concentration of the semiconductor substrate 10 at the contact edge, a distance between the first region 18 and the contact edge is preferably 5 µm or more, and is more preferably 10 µm or more. From a viewpoint of lowering a withstand voltage at the side portion, a distance between the first region 18 and the contact edge is preferably 50 µm or less.

A width of the first region 18 as viewed in a plan view is preferably at least twice as large as a depth of the activation region 14 in order to lower a withstand voltage at the side portion by sufficiently ensuring a portion where a side spreading portion (curvature portion) of the activation region 14 and the substrate region 12 (n⁻-type semiconductor region 12b) are in contact with each other. On the other hand, in a case where the first region 18 is too wide, an area of the activation region 14 becomes small and hence, the width of the first region 18 is preferably at most 10 times the depth of the activation region 14.

The channel stopper 19 is a region formed on a first main surface side at an outermost peripheral portion of the semiconductor substrate 10 as viewed in a plan view. The channel stopper 19 in the semiconductor device 1 is a region of a first conductive type (n-type in the semiconductor device 1) having a higher dopant concentration than the n⁺-type semiconductor region 12a.

The activation region-side electrode 20 is disposed on the first main surface of the semiconductor substrate 10.

The insulation layer 30 is in contact with an outer periphery of the activation region-side electrode 20, and is disposed on the first main surface. The insulation layer 30 in the semiconductor device 1 is disposed to cover a portion of the activation region 14 including its outer periphery, the surface semiconductor region 16, the substrate region 12 on an outer peripheral side of the surface semiconductor region 16, and a portion of the channel stopper 19 including its inner periphery.

The field plate 40 is in contact with an outer periphery of the activation region-side electrode 20, and is disposed on the insulation layer 30. Although the activation region-side electrode 20 and the field plate 40 are formed integrally as the first electrode in the semiconductor device 1, when the inner periphery of the insulation layer 30 is taken as a boundary as viewed in a plan view, a portion inside the inner periphery constitutes the activation region-side electrode 20, and a portion outside the inner periphery constitutes the field plate 40. In the semiconductor device 1, the field plate 40 is disposed so as to overlap with a portion of the activation region 14 and a portion of the surface semiconductor region 16 as viewed in a plan view.

The second electrode 50 is disposed on a second main surface on a side opposite to the first main surface of the semiconductor substrate 10.

Hereinafter, advantageous effects of the semiconductor device 1 according to the embodiment 1 are described.

In the semiconductor device 1 according to the embodiment 1, the semiconductor substrate 10 has the surface semiconductor region 16 of a second conductive type that is disposed on the first main surface side so as to be in contact with the outer periphery of the activation region 14 as viewed in a plan view, and has a smaller total amount of dopant than the activation region 14. In the semiconductor device 1 according to the embodiment 1, both the substrate region 12 and the surface semiconductor region 16 can be depleted when a reverse bias is applied and hence, it is unnecessary to increase the area of a peripheral region to obtain a high withstand voltage. As a result, according to the semiconductor device 1 of the embodiment 1, the semiconductor device 1 can achieve the miniaturization while attaining a higher withstand voltage than a semiconductor device having a guard ring structure.

In the semiconductor device 1 according to the embodiment 1, the semiconductor substrate 10 has the first region 18 that is formed to be positioned inside the corresponding first side portion 14b as viewed in a plan view, and has a smaller total amount of dopant than the activation region 14. A withstand voltage is determined based on the area over which the depletion layer spreads. In the semiconductor device 1 according to the embodiment 1, the first region 18 is formed inside the first side portion 14b of the activation region 14 and hence, the spreading of a depletion layer in the vicinity of the first region 18 is reduced thereby lowering a withstand voltage at a side portion. As a result, according to the semiconductor device 1 of the embodiment 1, it is possible to facilitate an avalanche breakdown in the side portion when a reverse bias is applied and hence, the withstand capability of the entire device can be increased.

Accordingly, the semiconductor device 1 according to the embodiment 1 can achieve the miniaturization of the semiconductor device 1 while providing a higher withstand voltage than a semiconductor device having a guard ring structure, and can increase the withstand capability of the entire device.

In the semiconductor device 1 according to the embodiment 1, a maximum depth of the activation region 14 is greater than a maximum depth of the surface semiconductor region 16. According to the semiconductor device 1 of the embodiment 1, the semiconductor device 1 can achieve a high withstand voltage even without forming the surface semiconductor region 16 deeply and hence, the productivity can be improved and production cost can be reduced.

In the semiconductor device 1 according to the embodiment 1, the first region 18 is a region having a smaller total amount of dopant than the activation region 14, and a maximum depth of the first region 18 is smaller than a maximum depth of the activation region 14. Accordingly, due to the presence of the first regions 18, a low total amount of dopant portion having a cylindrical shape is formed in the activation region 14 and hence, the side diffusion portions (curvature portions) of the activation region 14 in the vicinity of the portions and the substrate region 12 (n⁻-type semiconductor region 12b) come into contact with each other. The contact between the side diffusion portions (curvature portions) of the activation region 14 in the vicinity of the first regions 18 and the substrate region 12 (n⁻-type semiconductor region 12b) leads to the enhancement of an electric field strength in the vicinity of the contact portions. Accordingly, in the semiconductor device 1 according to the embodiment 1, a withstand voltage at the side portions can be further lowered thus further promoting the occurrence of an avalanche breakdown in the side portions when a reverse bias is applied whereby a withstand capability of the entire device can be further enhanced.

### [Embodiment 2]

A semiconductor device 2 according to an embodiment 2 has substantially the same basic configuration as the semiconductor device 1 according to the embodiment 1. However, the semiconductor device 2 according to the embodiment 2 differs from the semiconductor device 1 according to the embodiment 1 with respect to the shape of a surface semiconductor region. That is, in the semiconductor device 2, a surface semiconductor region 66 of a semiconductor substrate 60 has a rectangular outer peripheral shape as viewed in a plan view (see Fig. 2). That is, as viewed in a plan view, an outer periphery of a corner portion of the surface semiconductor region 66 is formed in an angular shape. A channel stopper 69 of the semiconductor substrate 60 has an inner peripheral shape that is a rectangular shape as viewed in a plan view corresponding to the shape of the surface semiconductor region 66. The configuration of the semiconductor substrate 60 is substantially equal to the configuration of the semiconductor substrate 10 in the embodiment 1 except for the shape of the surface semiconductor region 66 and the shape of the channel stopper 69. Due to the shape of the surface semiconductor region 66 and the shape of the channel stopper 69, an insulation layer 32 in the second semiconductor device 2 also has an outer peripheral shape that is a rectangular shape as viewed in a plan view.

The semiconductor device 2 according to the embodiment 2 differs from the semiconductor device 1 according to the embodiment 1 with respect to the shape of the surface semiconductor region. On the other hand, the semiconductor substrate 60 according to the embodiment 2 can similarly has the surface semiconductor region 66 and the first region 18. Accordingly, the semiconductor device 2 according to the embodiment 2 is a semiconductor device that can, in the same manner as the semiconductor device 1 according to the embodiment 1, achieve the miniaturization of the semiconductor device while achieving a higher withstand voltage than a semiconductor device having a guard ring structure, and can also enhance the withstand capability of the entire device.

Further, according to the semiconductor device 2 of the embodiment 2, the outer peripheral shape of the surface semiconductor region 66 has a rectangular shape as viewed in a plan view. Accordingly, when a reverse bias is applied, the structure promotes the spreading of the depletion layer from the corner portion of the surface semiconductor region 66 and hence, an electric field strength at a peak of the corner portion of the surface semiconductor region 66 can be alleviated whereby a withstand voltage at the corner portion can be enhanced. As a result, according to the semiconductor device 2 of the embodiment 2, when a reverse bias is applied, it is possible to further promote the occurrence of an avalanche breakdown in the vicinity of the side portion and hence, the withstand capability of the entire device can be further enhanced.

The semiconductor device 2 according to the embodiment 2 also exhibits other advantageous effects that the semiconductor device 1 according to the embodiment 1 acquires.

The present invention has been described above based on the above-mentioned embodiments. However, the present invention is not limited to the above-mentioned respective embodiments. The present invention can be carried out in various modes without departing from the gist of the present invention. For example, the following modifications are conceivable.
(1) The positions, the sizes and the like in the above-mentioned respective embodiments are provided for illustrative purposes, and these can be suitably changed provided that the technical scope of the present invention is not impaired.
(2) In the above-mentioned embodiments 2, the activation region 14 has substantially the same shape as the activation region 14 in the embodiment 1. However, the present invention is not limited to such a case. An activation region 74 of a semiconductor substrate 70 according to a semiconductor device 3 of a modification is a region of a second conductive type whose outer peripheral shape is a rectangular shape as viewed in a plan view, and has a plurality of first corner portions 74a and a plurality of first side portions 74b (see Fig. 3). The activation region 74 in the modification may be formed such that its outer peripheral shape as viewed in a plan view is rectangular. In a case where the rectangular shape is used as the outer peripheral shape of the activation region, a corner portion of a field plate is preferably formed in an arcuate shape having its center point at a peak of the corner portion of the activation region.
(3) In the above-mentioned respective embodiments, the first conductive type is set to the n-type and the second conductive type is set to the p-type. However, the present invention is not limited to such a case. The first conductive type may be set to the p-type, and the second conductive type may be set to n-type.
(4) The above-mentioned semiconductor devices 1, 2 according to the respective embodiments are each formed of a planar-type diode. However, the present invention is not limited to such a case. The present invention is also applicable to diodes of other types, a transistor (for example, MOSFET), a thyristor or the like besides the planar-type diode.

### [Reference Signs List]

1, 2, 3: semiconductor device
10, 60, 70: semiconductor substrate
12: substrate region
14, 74: activation region
14a, 74a: first corner portion
14b, 74b: first side portion
16, 66: surface semiconductor region
18: first region
20: activation region-side electrode
30, 32: insulation layer
40: field plate
50: second electrode

## Claims

1. A semiconductor device comprising:
a semiconductor substrate;
an activation region-side electrode disposed on a first main surface of the semiconductor substrate;
an insulation layer in contact with an outer periphery of the activation region-side electrode, and disposed on the first main surface; and
a field plate in contact with the outer periphery of the activation region-side electrode, and disposed on the insulation layer, wherein
the semiconductor substrate includes:
a substrate region of a first conductive type;
an activation region of a second conductive type that is formed on the first main surface side such that at least a portion of the activation region overlaps with the activation region-side electrode as viewed in a plan view, and has a plurality of first corner portions and a plurality of first side portions;
a surface semiconductor region of the second conductive type that is formed on the first main surface side to be in contact with an outer periphery of the activation region as viewed in a plan view, and has a smaller total amount of dopant than the activation region; and
a first region that is formed to be positioned inside the corresponding first side portion as viewed in a plan view, and has a smaller total amount of dopant than the activation region.

2. The semiconductor device according to claim 1, wherein a maximum depth of the activation region is greater than a maximum depth of the surface semiconductor region.

3. The semiconductor device according to claim 1 or 2, wherein the first region is a region of the second conductive type having a smaller total amount of dopant than the activation region, and
a maximum depth of the first region is less than a maximum depth of the activation region.

4. The semiconductor device according to any one of claims 1 to 3, wherein the surface semiconductor region has an outer peripheral shape that is a rectangular shape as viewed in a plan view.
